Europäisches Patentamt

European Patent Office

Office européen des brevets

(11) Veröffentlichungsnummer : **0 058 636**
**B1**

(12) **EUROPÄISCHE PATENTSCHRIFT**

(45) Veröffentlichungstag der Patentschrift :
**19.12.84**

(21) Anmeldenummer : **82810046.1**

(22) Anmeldetag : **04.02.82**

(51) Int. Cl.³ : **F 24 D 11/00, F 24 D 11/02,
F 24 D 17/00, F 24 J 3/00**

(54) Einrichtung zum Entzug von Wärme aus dem Abwasser und Verfahren zu deren Betrieb.

(30) Priorität : **16.02.81 CH 991/81**

(43) Veröffentlichungstag der Anmeldung :
**25.08.82 Patentblatt 82/34**

(45) Bekanntmachung des Hinweises auf die Patenterteilung : **19.12.84 Patentblatt 84/51**

(84) Benannte Vertragsstaaten :
**AT BE CH DE FR GB IT LI LU NL SE**

(56) Entgegenhaltungen :
**CA-A- 1 040 945
DE-A- 2 625 157
DE-A- 2 845 677
DE-A- 2 919 004**

(73) Patentinhaber : **Kalberer, Felix
Bahnweg 34
CH-7320 Sargans (CH)**

(72) Erfinder : **Kalberer, Felix
Bahnweg 34
CH-7320 Sargans (CH)**

(74) Vertreter : **Schmid, Rudolf et al
c/o ISLER & SCHMID Patentanwaltsbureau Walche-strasse 23
CH-8006 Zürich (CH)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft eine Einrichtung zum Entzug von Wärme aus dem Abwasser mittels in einem vom Abwasser durchflossenen Behälter angeordneten Wärmeaustauschern, gemäss dem Obergriff des unabhängigen Anspruchs 1, ferner betrifft die Erfindung ein Verfahren zum Betrieb der Einrichtung gemäss dem Anspruch 7.

Der Begriff Abwasser umfasst eine Vielzahl von Abwasserarten, die praktisch jede Art von Schmutzstoffen enthalten können. Abwasser aus sanitären Anlagen, Küchen und Kantinen von Betrieben entspricht weitgehend dem häuslichen Abwasser, das sich überwiegend aus Spül-, Wasch- und Reinigungsarbeiten sowie aus der Benützung der sanitären Anlagen ergibt. In Mitteleuropa wird mit einem Mittelwert von 150 Liter Wasserbedarf pro Einwohner und Tag gerechnet. In städtischen Gebieten kann der Abwasseranfall näherungsweise in der gleichen Grössenordnung angesetzt werden. Die Belastung an Schmutzstoffen beträgt etwa gleichbleibend rund 1 kg/m³. Davon nehmen Harn und Kot einen Anteil von rund der Hälfte ein. Aber neben diesen Schmutzstoffen führt das Abwasser auch einen beträchtlichen Anteil an Energie mit sich. Es ist bekannt, dass das Abwasser ein Mischtemperatur von bis 50° aufweisen kann und somit einen Wärmeinhalt von rund 210 J/kg hat. Bei einem Abwasseranfall von 150 Litern ergäbe dies einen theoretischen Energieverlust von 31'500 J. Die Wassertemperatur sollte jedoch in der Kanalisation einen minimalen Wert von 8 bis 10° nicht unterschreiten, damit die biologische Klärung stattfinden kann. Wenn der Wärmeinhalt des Wassers bei 10° mit 42 J/kg angesetzt wird, so kann dem Abwasser von einer Person pro Tag 25'000 J Wärme entnommen werden.

In der DE-A 26 25 157 ist eine Anlage zur Abwasserwärme-Rückgewinnung dargestellt. In einen Sammelbehälter mündet oben eine Abwasserleitung und unten befindet sich ein erster Auslauf mit einem Absperrventil. Eine Überlaufleitung mit einem Krümmer bildet einen zweiten Auslauf, mit dem das Absperrventil umgangen wird. Im Innenraum des Behälters befinden sich parallele, vertikal angeordnete Wärmetauscherplatten. Wenn das Abwasser Fäkalien enthält und somit einen hohen Schmutzgehalt aufweist, bildet sich ein Belag an den Wärmetauscherplatten, der eine häufige Reinigung verlangt. Eine soche Unterhaltsarbeit ist zeitaufwendig und daher teuer.

Es ist deshalb eine Aufgabe der Erfindung, bei einer Einrichtung der eingangs beschriebenen Art eine Lösung anzugeben, mit der die häufige Reinigung der Wärmetauscher vermieden werden kann, ohne dass dadurch die von den Schmutzstoffen mitgeführte Wärme verloren geht.

Erfindungsgemäss wird dies dadurch erreicht, dass zwischen dem Zufluss und dem ersten Abfluss eine Verbindungsleitung mit einer durch ein Grobsieb verschlossenen Überlauföffnung vorhanden ist, dass ferner der zweite Abfluss am Boden des Behälters mündet und mit einem zweiten Sperrventil versehen ist, und dass im Behälter ein die Verbindungsleitung mindestens im Bereich des Grobsiebes umfassendes Feinsieb zwischen Verbindungsleitung und Wärmeaustauschern angeordnet ist, derart, dass zwischen Zufluss und erstem Abfluss eine Verbindungsleitung mit einer durch ein Grobsieb verschlossenen Überlauföffnung vorhanden ist, dass der zweite Abfluss beim Boden des Behälters mündet und mit einem zweiten Sperrventil versehen ist, dass ferner im Behälter ein die genannte Verbindungsleitung mindestens im Bereich des Grobsiebes umfassendes Feinsieb zwischen Verbindungsleitung und Wärmetauschern angeordnet ist, und dass zwischen zweitem Abfluss und Krümmer ein Steigrohr angeordnet ist, um eine die Eintauchung der Wärmetauscher gewährleistende Füllhöhe einzustellen.

Das Verfahren zum Betrieb der Einrichtung ist dadurch gekennzeichnet, dass bei geschlossenem ersten und zweiten Sperrventil das Abwasser durch den Zufluss und durch das Grobsieb in den Behälter gelangt und diesen bis zu dem durch den Krümmer bestimmten Niveau konstant gefüllt hält, dass durch periodisches Öffnen des ersten Sperrventiles das Grobsieb durch Rückspülung gereinigt wird, dass ferner in bestimmten Abständen das zweite Sperrventil geöffnet wird, um unter Umgehung des Krümmers den zweiten Abfluss direkt mit der Kanalisationsleitung zu verbinden, und den Behälter von Feinschlamm zu säubern, und dass die Wärmerückgewinnung betrieben wird, wenn die Wärmetauscher im Abwasser eingetaucht sind und ausser Betrieb gesetzt wird, wenn die Temperatur des Abwassers eine untere Temperaturgrenze unterschreitet.

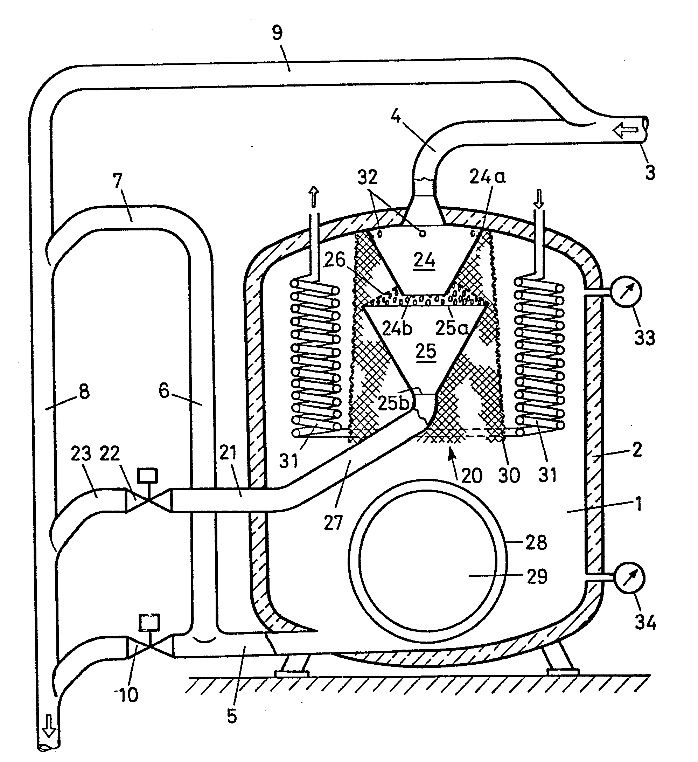

Ein Ausführungsbeispiel der Erfindung wird nachfolgend anhand der Zeichnung erläutert, in der eine schematische Schnittansicht einer Einrichtung nach der Erfindung dargestellt ist.

In einen Behälter 1 mit einer wärmeisolierten Wandung 2 ist eine Abwasserleitung 3 für häusliches Abwasser mit einem oben einmündenden Zufluss 4 zugeführt. Ein Abfluss 5 geht vom Boden des Behälters 1 weg und ist einerseits über ein Steigrohr 6 und einen Krümmer 7 und anderseits direkt über ein Sperrventil 10 in die Abwasserleitung 8 eingeleitet. Von der Abwasserleitung 3 ist eine Nebenschlussleitung 9 abgezweigt, die ebenfalls direkt in die Abwasserleitung 8 geführt ist ; sie dient als Notüberlauf sowie als Be- und Entlüftung.

Im Behälter 1 befindet sich eine Verbindungsleitung 20 zur Verbindung des Zuflusses 4 mit einem weiteren Abfluss 21, der über ein Sperrventil 22 mit einem Anschlussrohr 23 mit der Abwasserleitung 8 verbunden ist.

Die Verbindungsleitung 20 besteht aus zwei umgekehrten, kegelstumpfförmigen Hohlkörpern 24, 25, bei denen ein Grobsieb 26 die Grundlinie 25a des unteren Hohlkörpers 25 mit einer Stelle in der Nähe der deckflächenseitigen Begrenzungslinie 24b des oberen Hohlkörpers 24 verbindet. Die Grundlinie 24a des oberen Hohlkörpers 24 ist an der Wandung 2 befestigt, so dass der Zufluss 4 direkt in den oberen Hohlkörper 24 mündet. Die deckflächenseitige Begrenzungslinie 25a des unteren Hohlkörpers 25 ist mittels einer Ableitung 27 mit dem Abfluss 21 verbunden. Der Behälter 1 weist als weitere Öffnung ein Mannloch 28 auf, das in üblicher Weise durch einen angeschraubten Deckel 29 verschlossen ist.

Die beiden Hohlkörper 24, 25 sind von einem Feinsieb 30 umfasst, das ebenfalls an der Deckseite der Wandung 2 befestigt ist und sich nach unten wie ein umgekehrter Kegelstumpf ausweitet. Im Raum zwischen dem Feinsieb 30 und dem zylindrischen Teil der Wandung 2 befinden sich mehrere verteilt angeordnete Wärmeaustauscher 31, die beispielsweise wendelförmig gebogene Leitungen für ein Wärmetransportmittel sein können. Diese Wärmeaustauscher 31 bilden die Expander einer bekannten Wärmepumpe.

Im Betrieb wird das häusliche Abwasser durch die Abwasserleitung 3 und den Zufluss 4 in den Behälter 1 geleitet. Indem die Nebenschlussleitung 9 in einem nach oben verlaufenden Bogen abgezweigt ist, fliesst normalerweise kein Abwasser durch diese. Bei geschlossenem Sperrventil 22 füllt sich die Verbindungsleitung 20 bis zum Grobsieb 26. Das von grobem Schmutz befreite Abwasser gelangt somit in den Behälter 1. Die Luft in der Verbindungsleitung 20 kann durch Druckausgleichsöffnungen 32 nahe bei der Deckwand des Behälters 1 im oberen Hohlkörper 24 entweichen.

Mit einer Niveausonde 33 im oberen Bereich des Behälters 1 wird der Wasserstand gemessen, um bei genügendem Wasserpegel die Wärmepumpe einzuschalten. Die Niveausonde ist dazu derart angeordnet, dass sichergestellt werden kann, dass die Wärmeaustauscher 31 in das Abwasser eingetaucht sind. Mit einem im unteren Bereich des Behälters 1 angeordneten Thermostaten 34 kann die Wärmepumpe ausgeschaltet werden, wenn das schwerere kühle Wasser am Boden des Behälters eine Temperaturschwelle unterschreitet.

Wenn das Abwasser im Behälter 1 mindestens einen Pegel erreicht hat, der dem höchsten Punkt des Krümmers 7 entspricht, fliesst eine dem jeweils anfallenden Wasser entsprechende Menge in die Kanalisation ab.

Der Behälter 1 wird dementsprechend so ausgelegt, dass nahezu der gesamte Wärmeinhalt von einem Tag in den Nachtstunden entladen werden kann.

Während sich das Feinsieb 30 nur bei jeder Entleerung des Behälters 1 durch zurückfliessendes Wasser selbst reinigt, wird zur Reinigung des Grobsiebes 26 das Sperrventil 22 geöffnet, so dass auch hier das zurückströmende Wasser die anhaftenden und schwimmenden Schmutzteile wegspült.

Durch diese Einrichtung wird erreicht, dass relativ sauberes Abwasser um die Wärmeaustauscher 31 herum fliesst und die Verschmutzung ist dementsprechend gering, so dass die Reinigung in relativ grossen Abständen durchgeführt werden kann. Infolge des sich konisch nach unten ausweitenden Feinsiebes 30 können die durch das Feinsieb 30 abgeschiedenen Schwebstoffe nach unten absinken, ohne dass sie jemals mit den Wärmeaustauschern 31 in Berührung kommen. Dem Abwasser kann infolge der wärmebedingten Umschichtung der Wärmeinhalt so weit wie es erlaubt ist entzogen werden.

## Ansprüche

1. Einrichtung zum Entzug von Wärme aus Abwasser mittels Wärmetauschern (31) in einem Behälter (1), dem das Abwasser durch einen oben an diesem angeordneten Zufluss (4) zugeführt und mit einem im unteren Teil des Behälters (1) angeordneten, mit einem ersten Sperrventil (22) versehenen ersten Abfluss (21, 23) wegführbar ist, wobei am Behälter (1) ein zweiter, mit einem Krümmer (7) versehener Abfluss (5) vorhanden ist, dadurch gekennzeichnet, dass zwischen Zufluss (4) und erstem Abfluss (5) eine Verbindungsleitung (24, 25, 27) mit einer durch ein Grobsieb (26) verschlossenen Überlauföffnung vorhanden ist, dass der zweite Abfluss (5) beim Boden des Behälters (1) mündet und mit einem zweiten Sperrventil (10) versehen ist, dass ferner im Behälter (1) ein die genannte Verbindungsleitung (24, 25, 27) mindestens im Bereich des Grobsiebes (26) umfassendes Feinsieb (30) zwischen Verbindungsleitung und Wärmetauschern (31) angeordnet ist, und dass zwischen zweitem Abfluss (5) und Krümmer (7) ein Steigrohr (6) angeordnet ist, um eine die Eintauchung der Wärmetauscher gewährleistende Füllhöhe einzustellen.

2. Einrichtung nach Anspruch 1, dadurch gekennzeichnet, dass das Sperrventil (22) zwischen dem ersten Abfluss (21) und einem in die Kanalisationsleitung (8) mündenden Anschlussrohr (23) angeordnet ist.

3. Einrichtung nach Anspruch 2, dadurch gekennzeichnet, dass in der Verbindungsleitung (20) zwei stufig miteinander verbundene Hohlkörper (24, 25) vorhanden sind, und dass das Grobsieb (26) zwischen den beiden Hohlkörpern (24, 25) angeordnet ist.

4. Einrichtung nach Anspruch 3, dadurch gekennzeichnet, dass die beiden Hohlkörper (24, 25) kegelstumpfförmige Mantelflächen aufweisen, von denen die Grundflächen gegen den Zufluss (4) gerichtet sind, und dass das Grobsieb (26) die Grundfläche des unteren Hohlkörpers (25) bildet.

5. Einrichtung nach einem der Ansprüche 1 bis 4, dadurch gekennzeichnet, dass der obere Hohlkörper (24) nahe bei der Deckwand des Behälters (1) angeordnet ist, und dass in der Wand des oberen Hohlkörpers (24) Druckausgleichsöffnungen (32) angeordnet sind.

6. Einrichtung nach einem der Ansprüche 2 bis 5, dadurch gekennzeichnet, dass das Feinsieb (30) die Mantelfläche eines aufrechtstehenden Kegelstumpfes ist und an der Deckwand des Behälters (1) rund um den Zufluss (4) herum befestigt ist.

7. Verfahren zum Betrieb der Einrichtung nach Anspruch 1, dadurch gekennzeichnet, dass bei geschlossenen ersten und zweiten Absperrventilen (10, 22) das Abwasser durch den Zufluss (4) und durch das Grobsieb (26) in den Behälter (1) gelangt und diesen bis zu dem durch den Krümmer (6, 7, 8) bestimmten Niveau konstant gefüllt hält, dass durch periodisches Öffnen des ersten Sperrventiles (22) das Grobsieb (26) durch Rückspülung gereinigt wird, dass ferner in bestimmten Abständen das zweite Sperrventil (10) geöffnet wird, um unter Umgehung des Krümmers (6, 7, 8) den zweiten Abfluss (5) direkt mit der Kanalisationsleitung zu verbinden und den Behälter von Feinschlamm zu säubern, und dass die Wärmerückgewinnung betrieben wird, wenn die Wärmetauscher (31) im Abwasser eingetaucht sind und ausser Betrieb gesetzt wird, wenn die Temperatur des Abwassers eine untere Temperaturgrenze unterschreitet.

### Claims

1. An apparatus for removing heat from sewage by means of heat exchangers (31) in a tank (1) to which the sewage is supplied through a top entry (4) and from which the sewage is removable by way of a first outlet (21, 23) which is disposed in the bottom part of the tank (1) and which has a first stop valve (22), the tank (1) having a second outlet (5) which comprises a pipe bend (7), characterised in that a connecting line (24, 25, 27) associated with an overflow opening closed by a coarse filter (26) is present between the inlet or inflow (4) and the first outlet (5), the second outlet (5) enters the tank (1) in the bottom thereof and has a second stop valve (10), a fine filter (30) which extends around the connecting line (24, 25, 27) at least near the coarse filter (26) is disposed in the tank (1) between the connecting line and the heat exchangers (31), and a riser (6) is disposed between the second outlet (5) and the pipe bend (7) with a view to adjustability of the filling height ensuring immersion of the heat exchangers.

2. An apparatus according to claim 1, characterised in that the stop valve (22) is disposed between the first outlet (21) and a connecting pipe (3) which extends into the sewage pipe (8).

3. An apparatus according to claim 2, characterised in that two hollow members (24, 25) nestable in one another are present in the connecting line (20) and the coarse filter (26) is disposed between the two members (24, 25).

4. An apparatus according to claim 3, characterised in that the two hollow members (24, 25) have frustumshaped generated surfaces with the major surfaces facing the inflow or inlet (4), and the coarse filter (26) forms the major surface of the bottom member (25).

5. An apparatus according to any of claims 1 to 4, characterised in that the top hollow member (24) is disposed close to the tank top wall and the wall of the top hollow member (24) is formed with pressure-equalizing orifices (32).

6. An apparatus according to any of claims 2 to 5, characterised in that the fine filter (30) is the generated surface of a vertical frustum and is secured around the inlet (4) to the tank top wall.

7. A method of operating the apparatus according to claim 1, characterised in that with the first and second stop valves (10, 22) in the closed state, sewage flows through the inlet (4) and coarse filter (26) into the tank (1) and keeps the same filled to the level determined by the pipe bend (6, 7, 8), the coarse filter (26) is cleaned by backwashing by periodic opening of the first stop valve (22), the second stop valve (10) is opened at predetermined intervals in order to connect the second outlet (5) to the sewage line directly, bypassing the pipe bend (6, 7, 8), and to clean the tank of fine sludge, and heat recovery proceeds when the heat exchangers (31) are immersed in the sewage, heat recovery ceasing when the temperature of the sewage undershoots a bottom temperature limit.

### Revendications

1. Appareil pour la récupération de chaleur à partir d'eaux usées au moyen d'échangeurs thermiques (31) dans un réservoir (1) auquel les eaux usées sont délivrées par l'intermédiaire d'un raccord d'admission (4) disposé en haut de ce réservoir et peuvent être évacuées par un premier raccord d'évacuation (21, 23) disposé dans la partie inférieure dudit réservoir (1) et muni d'une première valve d'isolement (22), un second raccord d'évacuation (5) présentant un coude (7) étant situé sur ledit réservoir (1), appareil caractérisé par le fait qu'un conduit de jonction (24, 25, 27) comportant un orifice de trop plein obturé par un tamis grossier (26) est intercalé entre ledit raccord d'admission (4) et ledit premier raccord d'évacuation (5) ; par le fait que le second raccord d'évacuation (5) débouche dans le fond du réservoir (1) et est muni d'une seconde valve d'isolement (10) ; par le fait que ledit réservoir (1) loge, entre le conduit de jonction et les échangeurs thermiques (31), un tamis fin (30) qui entoure ledit conduit de jonction (24, 25, 27) au moins dans la région du tamis grossier (26) ; et par le fait qu'un tube ascendant (6) est intercalé entre le second raccord d'évacuation (5) et le coude (7) en vue de régler une hauteur de remplissage garantissant l'immersion des échangeurs thermiques.

2. Appareil selon la revendication 1, caractérisé par le fait que la valve d'isolement (22) est disposée entre le premier raccord d'évacuation (21) et un tube de raccordement (23) qui débouche dans le conduit (8).

3. Appareil selon la revendication 2, caractérisé par le fait que deux corps creux (24, 25) reliés l'un à l'autre de manière étagée sont situés dans le conduit de jonction (20) ; et par le fait que le tamis grossier (26) est intercalé entre ces deux corps creux (24, 25).

4. Appareil selon la revendication 3, caractérisé par le fait que les deux corps creux (24, 25) présentent des surfaces d'enveloppe tronconiques parmi lesquelles les surfaces délimitant les bases sont tournées vers le raccord d'admission (4) ; et par le fait que le tamis grossier (26) constitue la surface de base du corps creux inférieur (25).

5. Appareil selon l'une des revendications 1 à 4, caractérisé par le fait que le corps creux supérieur (24) est disposé à proximité de la paroi de recouvrement du réservoir (1) ; et par le fait que des orifices (32) d'équilibrage de pression sont élaborés dans la paroi de ce corps creux supérieur (24).

6. Appareil selon l'une des revendications 2 à 5, caractérisé par le fait que le tamis fin (30) constitue la surface d'enveloppe d'un tronc de cône reposant sur sa base et est fixé, à la paroi de recouvrement du réservoir (1), tout autour du raccord d'admission (4).

7. Procédé pour faire fonctionner l'appareil selon la revendication 1, caractérisé par le fait que, lorsque les première et seconde valves d'isolement (10, 22) sont fermées, les eaux usées parcourent le raccord d'admission (4) et traversent le tamis grossier (26) pour parvenir dans le réservoir (1), et maintiennent ce dernier empli en permanence jusqu'au niveau déterminé par le coude (6, 7, 8) ; par le fait que le tamis grossier (26) est nettoyé par rinçage à contre-courant grâce à une ouverture périodique de la première valve d'isolement (22) ; par le fait que la seconde valve d'isolement (10) est en outre ouverte, par intervalles déterminés, afin de relier directement le second raccord d'évacuation (5) à la canalisation en contournant le coude (6, 7, 8) et afin de débarrasser le réservoir des boues fines ; et par le fait qu'il est procédé à la récupération de chaleur lorsque les échangeurs thermiques (31) sont immergés dans les eaux usées, cette récupération étant interrompue lorsque la température des eaux usées tombe en deçà d'une limite inférieure de température.